# EUROPEAN PATENT SPECIFICATION

(11) **EP 4 177 872 B1**
(45) Date of publication and mention of the grant of the patent: **20.05.2026**
(21) Application number: 21832006.7
(22) Date of filing: 02.07.2021
(51) Int. Cl.: G02F 1/1335, G02F 1/1333, G09F 9/30, G09F 9/33, G02B 5/02, H10K 59/80, G02B 1/12, G02B 1/14

(54) **DISPLAY SCREEN AND ELECTRONIC DEVICE**
ANZEIGEBILDSCHIRM UND ELEKTRONISCHE VORRICHTUNG
ÉCRAN D'AFFICHAGE ET DISPOSITIF ÉLECTRONIQUE

(30) Priority: 03.07.2020 CN 202010635326
(43) Date of publication of application: 10.05.2023
(73) Proprietor: Huawei Technologies Co., Ltd., Shenzhen, Guangdong 518129 (CN)
(72) Inventor: ZHU, Ming, Shenzhen, Guangdong 518129 (CN); ZHOU, Xunping, Shenzhen, Guangdong 518129 (CN); NI, Huan, Shenzhen, Guangdong 518129 (CN); WANG, Yongxiang, Shenzhen, Guangdong 518129 (CN); ZHAO, Dachun, Shenzhen, Guangdong 518129 (CN); ZHANG, Jingfei, Shenzhen, Guangdong 518129 (CN); RUAN, Shibin, Shenzhen, Guangdong 518129 (CN)
(74) Representative: Thun, Clemens
(86) International application number: PCT/CN2021/104357
(87) International publication number: WO 2022/002268

(56) References cited:
- CN-A- 101 978 292
- CN-A- 103 982 827
- CN-A- 106 842 393
- CN-A- 110 082 848
- CN-A- 110 824 802
- CN-A- 112 125 531
- CN-U- 210 376 735
- KR-B1- 101 525 972
- US-A1- 2012 064 296
- US-A1- 2020 066 688

## Description

### CROSS-REFERENCE TO RELATED APPLICATIONS

### TECHNICAL FIELD

This application relates to the field of display screen technologies, and in particular, to a display screen, a display screen protective film, and an electronic device.

### BACKGROUND

Paper reading is a familiar reading mode, for example, reading books, newspapers, and manuals. Paper reading depends on ambient light of appropriate intensity. The ambient light is irradiated on a paper surface and reflected by the paper surface and then received by human eyes. Because the ambient light reflected by the paper surface is near-Lambertian reflection (a type of diffuse reflection), there is no display interference caused by specular reflection. Especially when the ambient light is strong, compared with the specular reflection, the ambient light reflected by the paper surface is less harmful to the human eye and more comfortable.

In view of this, paper-like display has also become one of the development trends of display screens. The paper-like display is to specially design a display screen, to reduce specular reflection of the display screen on ambient light, so that the display screen can also achieve display effect of paper reading. Currently, common paper-like display mainly includes transmissive paper-like display and reflective paper-like display. The transmissive paper-like display does not depend on ambient light, is flexibly applicable to more scenarios, and the use experience is more stable. The transmissive paper-like display is expected to become a mainstream of paper-like display in the future.

Currently, a transmissive paper-like display screen is mostly provided with a rough light exit surface, so that ambient light can be diffused on the light exit surface. Therefore, paper-like display effect is achieved. However, the rough light exit surface causes a flash point on a display picture of the display screen. That is, the display picture has uneven chrominance and luminance. Therefore, the current transmissive paper-like display screen still needs to be further improved.
The document US 2012/0064296 A1 shows an anti-glare film comprising a microstructured surface. Especially, the use of peaks and valleys in the microstructured surface for preventing a specular reflection is shown.

### SUMMARY

The present invention is defined by the independent claims. Further advantageous developments are shown by the dependent claims.

In view of this, this application provides a display screen, a display screen protective film, and an electronic device, to suppress a flash point of the display screen and implement paper-like display.

According to a first aspect, an embodiment of this application provides a display screen, mainly including a display panel and a transmissive layer that are sequentially stacked. The display panel may generate a display light ray, and the transmissive layer may transmit the display light ray. In this embodiment of this application, the transmissive layer has a first surface away from the display panel, the first surface includes a plurality of micro structural units, an orthographic projection of each micro structural unit along a thickness direction is located in a pixel region, and a projection area of the micro structural unit is less than or equal to an area of the pixel region. The micro structural unit may be a curved surface. In this embodiment of this application, the pixel region may include a region in which a sub-pixel is located on the display panel, and a spaced region between the sub-pixel and another sub-pixel that is located around the sub-pixel and adjacent to the sub-pixel.

For example, the display panel may be an LED display panel, an OLED display panel, an LCD panel, or the like. This is not limited in this embodiment of this application.

In the display screen provided in this embodiment of this application, an orthographic projection of a single micro structural unit is located in a pixel region, and a projection area of the single micro structural unit is less than or equal to an area of the pixel region. In other words, the orthographic projection of the single micro structural unit covers only a part or all of a region in which a maximum of one sub-pixel is located. Because the orthographic projection of the single micro structural unit covers only a part or all of the region in which a maximum of one sub-pixel is located, the micro structural unit mainly bends a light ray generated by the sub-pixel. This can avoid that the single micro structural unit bends light rays generated by different sub-pixels to some extent. Because a quantity of flash points are generated if micro structural units differently bend light rays of different sub-pixels, an intensity ratio of the three primary colors in the pixel is deviated, and consequently the flash points are generated. Therefore, in the display screen provided in this embodiment of this application, each micro structural unit mainly bends a display light ray of one sub-pixel. This helps reduce a difference in refraction degrees of light rays between different sub-pixels, and further helps optimize a flash point.
To further suppress the flash point, in a possible implementation, orthographic projections of at least two micro structural units are located in a sub-region of the pixel region, and the sub-region includes a region in which the sub-pixel is located and a spaced region between the sub-pixel and any adjacent sub-pixel.

The orthographic projections of the at least two micro structural units being located in the sub-region may also be understood as that a maximum size of the micro structural unit is not greater than 1/2 of a pixel pitch (pixel pitch). It is found through research that when the maximum size of the micro structural unit exceeds 1/2 of the pixel pitch, a speckle area increases rapidly with an increase of the maximum size of the micro structural unit. When the maximum size of the micro structural unit exceeds the pixel pitch, the speckle reaches a larger value. In view of this, in the display screen provided in this embodiment of this application, the orthographic projections of the at least two micro structural units are located in the sub-region of the pixel region. In other words, the maximum size of the micro structural unit is not greater than 1/2 of the pixel pitch. This helps control the speckle area within a small range, and optimize the flash point.

Generally, a height of each micro structural unit on the first surface is any value in [0.5 µm, 1.5 µm]. Specifically, the height of each micro structural unit may be 0.5 µm, or may be 1.5 µm, or may be any value greater than 0.5 µm and less than 1.5 µm. The height of each micro structural unit is a distance between a peak point and a valley bottom of the micro structural unit. The peak point of the micro structural unit is a point that is in the micro structural unit and that is at a maximum distance from the display panel. The valley bottom of the micro structural unit is a point that is in the micro structural unit and that is at a minimum distance from the display panel.

Further, the height of each micro structural unit on the first surface may alternatively be any value in [1.5 µm, 4 µm]. Specifically, the height of each micro structural unit may be 1.5 µm, or may be 4 µm, or may be any value greater than 1.5 µm and less than 4 µm.

To improve paper-like display effect, in a possible implementation, in any length range that is on the first surface and that is parallel to any direction of the display panel, an arithmetic average height Ra of the plurality of micro structural units is any value in [0.1 µm, 1 µm]. Specifically, the arithmetic average height Ra may be 0.1 µm, or may be 1 µm, or may be any value greater than 0.1 µm and less than 1 µm.

Further, the arithmetic average height Ra of the plurality of micro structural units may alternatively be any value in [0.2 µm, 0.5 µm]. Specifically, the arithmetic average height Ra may be 0.2 µm, or may be 0.5 µm, or may be any value greater than 0.2 µm and less than 0.5 µm.

The arithmetic average height Ra represents an arithmetic average value of absolute values of vertical distances between tangent-plane contour lines of the plurality of micro structural units and a center line in the any length range on a longitudinal tangent plane along the any direction and the thickness direction. The center line is a straight line that is on the longitudinal tangent plane and that is parallel to the any direction, and a sum of areas of a plurality of regions formed by the tangent-plane contour lines of the plurality of micro structural units and the center line is the same as a sum of areas of a plurality of regions formed by tangent-plane contour lines of every two adjacent micro structural units and the center line.

The arithmetic average height Ra can reflect an average height of the plurality of micro structural units. When the arithmetic average height Ra is excessively small, specular reflection is generated. This is not conducive to implementing paper-like display effect. When the arithmetic average height Ra is excessively large, definition of the display screen is lowered, and display contrast is also lowered in ambient light. Therefore, in this embodiment of this application, the arithmetic average height Ra may be any value in [0.1 µm, 1 µm]. This helps maintain the definition of the display screen and implement paper-like display. Further, when the arithmetic average height Ra may be any value in [0.2 µm, 0.5 µm], paper-like display effect is good, and definition is higher.

To improve paper-like display effect, in a possible implementation, on the first surface, density of the micro structural units is greater than or equal to 5000/mm².

Specifically, there are at least 5000 micro structural units in a plane range of any 1 mm² on the first surface. It may be understood that, when the density of the micro structural units on the first surface is excessively small, specular reflection is also generated on the first surface. This is not conducive to implementing paper-like display effect. In view of this, in this embodiment of this application, the density of the micro structural units on the first surface is not less than 5000/mm², to prevent specular reflection from being generated on the first surface. This helps implement paper-like display effect.

To further suppress the flash point, in a possible implementation, in any length range that is on the first surface and that is parallel to any direction of the display panel, a ratio Ra/Rsm of an arithmetic average height Ra of the plurality of micro structural units to an average length Rsm of contour curve elements of the plurality of micro structural units is greater than or equal to 0.5%.

The arithmetic average height Ra represents an arithmetic average value of absolute values of vertical distances between tangent-plane contour lines of the plurality of micro structural units and a center line in the any length range on a longitudinal tangent plane along the any direction and the thickness direction. The center line is a straight line that is on the longitudinal tangent plane and that is parallel to the any direction, and a sum of areas of a plurality of regions formed by the tangent-plane contour lines of the plurality of micro structural units and the center line is the same as a sum of areas of a plurality of regions formed by tangent-plane contour lines of every two adjacent micro structural units and the center line.

The average length Rsm of the contour curve elements represents an average value of projection lengths, on the center line, of connection lines between peak points of tangent-plane contour lines of every two adjacent micro structural units in the tangent-plane contour lines of the plurality of micro structural units in the any length range on the longitudinal tangent plane along the any direction and the thickness direction. A peak point of each tangent-plane contour line is a point that is in the tangent-plane contour line and that is farthest from the display panel.

It is found through research that a larger Ra/Rsm value is more conducive to suppressing a flash point. Therefore, in this embodiment of this application, a value of Ra/Rsm is not less than 0.5%, to further suppress the flash point.

To improve paper-like display effect, in a possible implementation, within a range of 1° deviation from a reflection angle, attenuation of reflected light of the first surface is less than or equal to 5%. It is found through research that, in a medium luminance range of 11.89 to 142.3 cd/m², a relationship between a minimum visual perceptible difference luminance of human eyes and background luminance meets the Weber's Law, and a ratio of the two is approximately equal to 0.017. In other words, when a modulation transfer function of a reflection image is greater than or equal to 0.017, the human eye can perceive the reflection image. In this application, the attenuation of the reflected light of the first surface is less than 5% within a range of 1° deviation from the reflection angle, so that the modulation transfer function MTF of the reflection image is less than 0.17, and a user cannot perceive specular reflection. This facilitates paper-like display.

In addition, in another possible implementation, within a range of 1° deviation from a reflection angle, attenuation of the reflected light of the first surface is any value in [5%, 10%]. It is difficult for the user to observe the specular reflection. This facilitates paper-like display.

To further suppress the flash point, in a possible implementation, the display screen may further include an intermediate layer. The intermediate layer is located between the display panel and the transmissive layer. The intermediate layer is configured to scatter the display light ray.

It is found through research that, when a scattering degree of the display light ray is high, the flash point of the display screen gradually decreases with an increase of the scattering degree of the display light ray. However, if a scattering capability of the first surface is excessively improved, definition of the display screen is lowered. In view of this, in this embodiment of this application, the intermediate layer is disposed between the display panel and the transmissive layer. Based on the first surface, the intermediate layer further improves the scattering degree of the display light ray, to suppress the flash point of the display screen. In addition, compared with the transmissive layer, the intermediate layer may be disposed at a position closer to the display panel. This helps reduce impact on definition of the display screen.

It should be noted that the intermediate layer may be a layer newly added to an original display screen structure, or may be an existing functional layer in the display screen. In other words, in addition to scattering the display light ray, the intermediate layer may further implement another function. An example is as follows.

For example, the intermediate layer may include an optical adhesive layer. The optical adhesive layer can not only adhere the display panel to the transmissive layer, but also scatter the display light ray. In a possible implementation, the intermediate layer may include a first optical adhesive layer, a second optical adhesive layer, and a third optical adhesive layer that are stacked. The second optical adhesive layer is located between the first optical adhesive layer and the third optical adhesive layer. The second optical adhesive layer includes a scattering particle. The first optical adhesive layer is disposed on a surface that is of the second optical adhesive layer and that is close to the display panel. The third optical adhesive layer is disposed on a surface that is of the second optical adhesive layer and that is close to the transmissive layer.

In this implementation, the optical adhesive layer is of a sandwich structure. The second optical adhesive layer may have a function of enhancing scattering, and the first optical adhesive layer and the third optical adhesive layer may maintain an original function of the optical adhesive layer, to prevent the scattering particle from affecting an adhesive effect of the optical adhesive layer.

For another example, the intermediate layer may include a touch layer. The touch layer can not only generate a touch signal, but also scatter the display light ray.

In another possible implementation, the display panel includes an intermediate layer. The intermediate layer is disposed close to the transmissive layer. The intermediate layer is configured to scatter the display light ray. For example, the intermediate layer may include a polarizing layer of the display panel.

In this embodiment of this application, haze haze of the intermediate layer is any value in [5%, 40%]. In other words, the haze of the intermediate layer may be 5%, or may be 40%, or may be any value greater than 5% and less than 40%. When the haze of the intermediate layer is small, it is not enough to significantly suppress the flash point. When the haze of the intermediate layer is large, definition of the display screen is affected. In this embodiment of this application, the haze of the intermediate layer is set to any value in [5%, 40%], to suppress the flash point and maintain the definition of the display screen.

In this embodiment of this application, haze haze of the intermediate layer may alternatively be any value in [40%, 95%]. In other words, the haze of the intermediate layer may be 40%, or may be 95%, or may be any value greater than 40% and less than 95%. According to the solution, the flash point can be suppressed while the definition of the display screen can be maintained.

For example, the intermediate layer may include the scattering particle, and the scattering particle may adjust the haze of the intermediate layer. For example, a scattering capability (the haze) of the intermediate layer may be adjusted by changing a plurality of factors such as a concentration of the scattering particle, a refractive index of the scattering particle, and a size of the scattering particle.

Generally, the refractive index of the scattering particle may be any value in [1.4, 2.5]. In other words, the refractive index of the scattering particle may be 1.4, or may be 2.5, or may be any value greater than 1.4 and less than 2.5.

To further suppress the flash point, in a possible implementation, an area of an orthographic projection of the scattering particle along the thickness direction is not greater than an area of the orthographic projection of the micro structural unit along the thickness direction. In this case, similar to the micro structural unit, the scattering particle in the intermediate layer bends only a light ray generated by one sub-pixel, and the light ray bent by the scattering particle is incident to a corresponding micro structural unit. Therefore, different micro structural units may receive similar incident light rays. This further helps suppress the flash point.

In the display screen provided in this embodiment of this application, the transmissive layer has a plurality of possible implementations. For example, the transmissive layer may include a cover plate, and a surface that is of the cover plate and that is away from the display panel may be used as the first surface of the transmissive layer. For another example, the transmissive layer not only includes a cover plate, but also may include a coating film. The cover plate is disposed between the display panel and the coating film. One surface of the coating film is fastened to the cover plate, and the other surface of the coating film is the first surface of the transmissive layer. For example, the coating film may be an anti-reflection coating film.

According to a second aspect, an example of this application further provides a display screen protective film. The display screen protective film may be laminated to a light exit surface of the display screen by pasting or vacuum adsorption. The display screen protective film includes a rough surface. The rough surface may include a plurality of micro structural units. An orthographic projection of each micro structural unit along a thickness direction is located in a pixel region, and a projection area of the micro structural unit is less than or equal to an area of the pixel region. The micro structural unit is a curved surface. In this embodiment of this application, the pixel region includes a region in which a sub-pixel is located on the display screen and a spaced region between the sub-pixel and another sub-pixel that is located around the sub-pixel and adjacent to the sub-pixel.

The display screen protective film provided in this example of this application can enable a non-paper-like display screen to implement paper-like display, and can further suppress a flash point. The rough surface of the display screen protective film provided in this embodiment of this application has a topography feature similar to that of the first surface of the transmissive layer in the first aspect. Details are not described again. For a technical effect of a corresponding solution in the second aspect, refer to a technical effect that can be obtained by using the corresponding solution in the first aspect. Details are not described herein.

To further suppress the flash point, in a possible implementation, orthographic projections of at least two micro structural units are located in a sub-region of the pixel region. The sub-region may include a region in which the sub-pixel is located and a spaced region between the sub-pixel and any adjacent sub-pixel.

Generally, a height of each micro structural unit is any value in [0.5 µm, 1.5 µm]. The height of each micro structural unit is a distance between a peak point and a valley bottom of the micro structural unit. Specifically, the peak point of the micro structural unit is a point that is in the micro structural unit and that is at a maximum distance from the display screen. The valley bottom of the micro structural unit is a point that is in the micro structural unit and that is at a minimum distance from the display screen.

Further, a height of the micro structural unit may be any value in [1.5 µm, 4 µm]. Specifically, the height of each micro structural unit may be 1.5 µm, or may be 4 µm, or may be any value greater than 1.5 µm and less than 4 µm.

To improve paper-like display effect, in a possible implementation, in any length range that is on the rough surface and that is parallel to any direction of the display screen, an arithmetic average height Ra of the plurality of micro structural units is any value in [0.1 µm, 1 µm]. The arithmetic average height Ra represents an arithmetic average value of absolute values of vertical distances between tangent-plane contour lines of the plurality of micro structural units and a center line in the any length range on a longitudinal tangent plane along the any direction and the thickness direction. The center line is a straight line that is on the longitudinal tangent plane and that is parallel to the any direction, and a sum of areas of a plurality of regions formed by the tangent-plane contour lines of the plurality of micro structural units and the center line is the same as a sum of areas of a plurality of regions formed by tangent-plane contour lines of every two adjacent micro structural units and the center line.

Further, the arithmetic average height Ra of the plurality of micro structural units may alternatively be any value in [0.2 µm, 0.5 µm]. Specifically, the arithmetic average height Ra may be 0.2 µm, or may be 0.5 µm, or may be any value greater than 0.2 µm and less than 0.5 µm.

To improve paper-like display effect, in a possible implementation, on the rough surface, density of the micro structural units is greater than or equal to 5000/mm².

To further suppress the flash point, in any length range that is on the rough surface and that is parallel to any direction of the display screen, a ratio Ra/Rsm of an arithmetic average height Ra of the plurality of micro structural units to an average length Rsm of contour curve elements of the plurality of micro structural units is greater than or equal to 0.5%. A meaning of the arithmetic average height Ra is not described again. The average length Rsm of the contour curve elements represents an average value of projection lengths, on the center line, of connection lines between peak points of tangent-plane contour lines of every two adjacent micro structural units in the tangent-plane contour lines of the plurality of micro structural units in the any length range on the longitudinal tangent plane along the any direction and the thickness direction. A peak point of the tangent-plane contour line is a point that is in the tangent-plane contour line and that is farthest from the display screen.

In a possible implementation, the display screen protective film is an anti-reflection coating film, to help suppress interference of ambient light to contrast of a display picture, and eliminate a "picture bleaching" problem caused by diffuse reflection.

According to a third aspect, an embodiment of this application provides an electronic device. The electronic device includes the display screen provided in any one of the first aspect. For example, the electronic device may be a common mobile terminal such as a mobile phone, a tablet computer, or an e-book reader, or may be an electronic device such as a notebook computer, a desktop computer, or a television.

According to a fourth aspect, an example of this application provides an electronic device, including a display screen and the display screen protective film provided in the second aspect. The display screen protective film is fastened on a light exit surface of the display screen, and a rough surface of the display screen protective film is disposed away from the display screen. The display screen may be a conventional non-paper-like display screen. By using the display screen protective film provided in this example of this application, the display screen of the electronic device can also achieve paper-like display, and a flash point of the display screen can further be suppressed.

These aspects or other aspects in this application may be clearer and more intelligible in descriptions in the following embodiments.

### BRIEF DESCRIPTION OF DRAWINGS

FIG. 1 is a schematic diagram of a structure of a side section of a transmissive display screen;
FIG. 2 is a schematic diagram of a structure of an LCD panel;
FIG. 3 is a schematic diagram of a structure of a pixel array;
FIG. 4 is a schematic diagram of a structure of an LED display panel;
FIG. 5 is a schematic diagram of a structure of an OLED display panel;
FIG. 6a is a schematic diagram of luminance distribution in a monochrome display picture when a first surface of a transmissive layer is a smooth plane;
FIG. 6b is a schematic diagram of luminance distribution in a monochrome display picture when a first surface of a transmissive layer is a rough surface;
FIG. 6c is a schematic diagram of chrominance distribution in a monochrome display picture when a first surface of a transmissive layer is a smooth plane;
FIG. 6d is a schematic diagram of chrominance distribution in a monochrome display picture when a first surface of a transmissive layer is a rough surface;
FIG. 7 is a schematic diagram of a structure of a display screen according to an embodiment of this application;
FIG. 8 is a top view of a first surface along a thickness direction according to an embodiment of this application;
FIG. 9 is a schematic diagram of a correlation relationship between a speckle area and a maximum size of a micro structural unit according to an embodiment of this application;
FIG. 10 is a schematic diagram of a longitudinal tangent plane of a transmissive layer according to an embodiment of this application;
FIG. 11 is a schematic diagram of a specific structure of a display screen according to an embodiment of this application; and
FIG. 12 is a schematic diagram of a specific structure of a display screen according to an embodiment of this application.

### DESCRIPTION OF EMBODIMENTS

To make the objectives, technical solutions, and advantages of this application clearer, the following further describes this application in detail with reference to the accompanying drawings. It should be noted that the terms used in the following embodiments are merely for the purpose of describing specific embodiments, but are not intended to limit this application. As used in the specification and appended claims of the application, singular expressions "one", "a", "the", "the foregoing", "this", and "the one" are also intended to include expressions such as "one or more", unless the contrary is clearly indicated in its context.

Reference to "an embodiment", "some embodiments", or the like described in embodiments of this application means that one or more embodiments of this application include a specific feature, structure, or characteristic described with reference to embodiments. Therefore, statements such as "in an embodiment", "in some embodiments", "in some other embodiments", and "in other embodiments" that appear at different places in embodiments of this application do not necessarily mean referring to a same embodiment. Instead, the statements mean "one or more but not all of embodiments", unless otherwise specifically emphasized in another manner. The terms "comprise", "include", "have", and other variants thereof all mean "include but is not limited to", unless otherwise specifically emphasized in another manner.

To improve paper-like display effect of a transmissive display screen, an embodiment of this application provides a display screen, to reduce impact of a flash point of the display screen on display effect and implement paper-like display. It should be noted that the display screen provided in this embodiment of this application may be applied to any electronic device having a display function, for example, may be used as a display screen of a common mobile terminal such as a mobile phone, a tablet computer, or an e-book reader, or may be used as a display screen of an electronic device such as a notebook computer, a desktop computer, or a television.

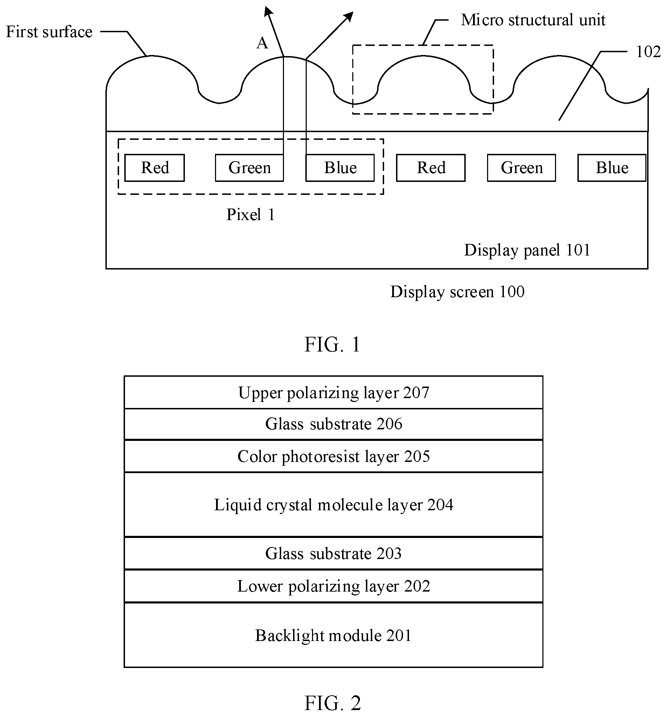

The display screen provided in this embodiment of this application may be a transmissive display screen. "Transmissive" may be understood as that the display screen can generate a display light ray inside, and emit the display light ray from a light exit surface of the display screen. For example, FIG. 1 is a schematic diagram of a structure of a side section of a transmissive display screen. It can be learned from FIG. 1 that a display screen 100 may include a display panel 101 and a transmissive layer 102, and the transmissive layer 102 and the display panel 101 are stacked. One surface of the transmissive layer 102 is disposed close to a light exit surface of the display panel 101, and the other surface that is of the transmissive layer 102 and that is away from the display panel 101 may be used as a light exit surface of the display screen 100. The display panel 101 may emit a display light beam, and the display light beam may be transmitted from the transmissive layer 102, to implement transmissive display.

The following further describes the display panel 101 and the transmissive layer 102 by using examples.

### 1. Display panel 101

According to different light-emitting principles, there are a plurality of types of display panels 101, and common display panels mainly include a liquid crystal display (liquid crystal display, LCD) panel, a light-emitting diode (light-emitting diode, LED) display panel, an organic light-emitting diode (organic light-emitting diode, OLED) display panel, and the like.

Generally, the display panel 101 may include a light-emitting structure, and the light-emitting structure may generate a light ray when the display panel 101 works. In addition to the light-emitting structure, the display panel 101 may further include another functional layer based on different types of the display panel 101. These functional layers are combined with the light-emitting structure, so that the display panel 101 can generate a display light ray, to implement a display function. The display light ray may be understood as a light ray that is generated by the display panel 101 and that is used for presenting a display picture. After the display light ray is received by human eyes, a user can observe the display picture.

An LCD panel is used as an example. A structure of the LCD panel may be shown in FIG. 2, and mainly includes a backlight module (backlight unit, BLU) 201, a lower polarizing layer 202, a glass substrate 203, a liquid crystal molecule layer 204, a color photoresist layer 205, a glass substrate 206, and an upper polarizing layer 207 that are sequentially stacked. The backlight module 201 is a light-emitting structure of the LCD panel, and is configured to generate a light ray of non-polarized light. The lower polarizing layer 202 may convert the non-polarized light generated by the backlight module 201 into linearly polarized light.

The glass substrate 203 and the glass substrate 206 are configured to wrap the liquid crystal molecular layer 204 and the color photoresist layer 205. An arrangement manner of liquid crystal molecules in the liquid crystal molecule layer 204 is controllable, and a polarization direction of the light ray may be changed by changing the arrangement manner of the liquid crystal molecules.

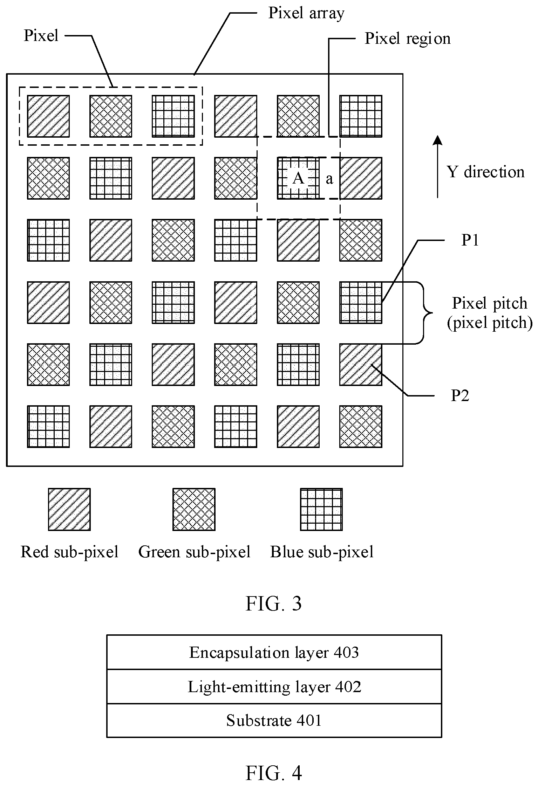

The color photoresist layer 205 includes photoresist arranged in an array, and the photoresist arranged in an array may also be understood as a pixel array of the LCD panel. For example, as shown in FIG. 3, the pixel array includes a plurality of pixels arranged in an array, and each pixel includes three sub-pixels (the photoresist), respectively corresponding to three colors: red, green, and blue.

The lower polarizing layer 202 and the upper polarizing layer 207 are disposed orthogonally, and the linearly polarized light transmitted by the lower polarizing layer 202 cannot be directly transmitted to the upper polarizing layer 207. Therefore, a polarization state of a light ray that is incident to each sub-pixel may be adjusted by using the liquid crystal molecule layer 204, to control transmissive intensity of the light ray that is from each sub-pixel and that is transmitted from the upper polarizing layer 207.

For example, for a sub-pixel that does not need to emit light, the liquid crystal molecule layer 204 may keep a polarization state of a light ray that is incident to the sub-pixel unchanged, that is, a polarization state of a light ray that is transmitted by the lower polarizing layer 202. Therefore, the light ray transmitted from the sub-pixel that does not need to emit light cannot continue to be transmitted from the upper polarizing layer 207, that is, the sub-pixel cannot emit light.

However, for a sub-pixel that needs to emit light, the liquid crystal molecule layer 204 may adjust a polarization state of a light ray that is incident to the sub-pixel (adjust a polarization angle). For the light ray transmitted from the sub-pixel that needs to emit light, light rays of different polarization angles may be transmitted from the upper polarizing layer 207 in different intensity. Therefore, light-emitting intensity of the sub-pixel may be controlled by adjusting the polarization state of the light ray that is incident to the sub-pixel.

An LED display panel is used as an example. As shown in FIG. 4, the LED display panel mainly includes a substrate 401, a light-emitting layer 402, and an encapsulation layer 403 that are sequentially stacked. The substrate 401 may carry the light-emitting layer 402. The light-emitting layer 402 is a light-emitting structure of the LED display panel, and includes a pixel array. An arrangement manner of the pixel array in the LED display panel is similar to that of the LCD panel, and may also be shown in FIG. 4. A difference lies in that the pixel array of the LED display panel includes LEDs corresponding to three colors: red, green, and blue, and the pixel array of the LED display panel itself can emit light electrically (or photoinduced). The encapsulation layer 403 covers the light-emitting layer 402, to protect an internal structure of the LED display panel.

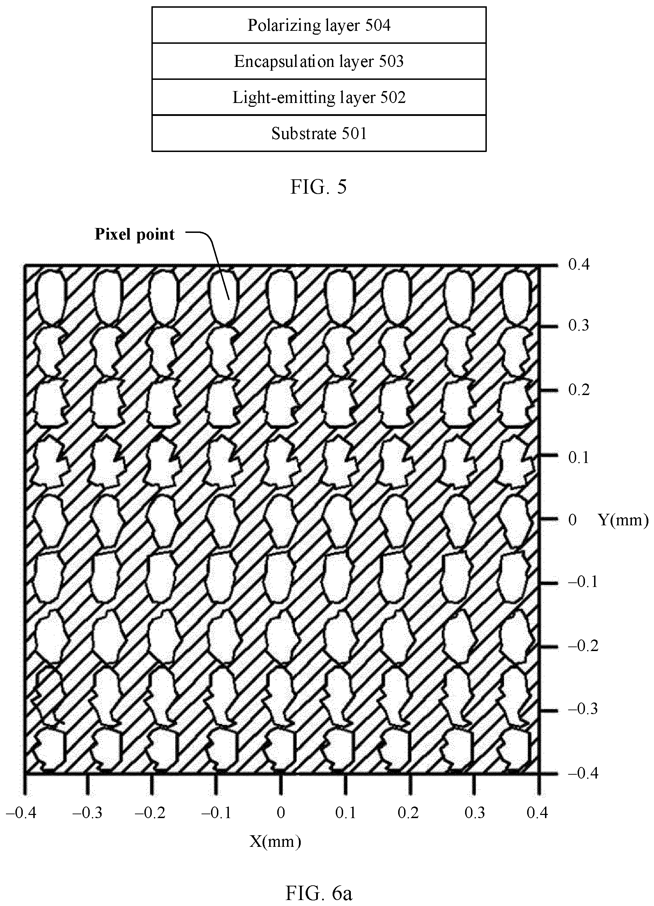

A structure of the OLED display panel is similar to that of the LED display panel. As shown in FIG. 5, the OLED display panel mainly includes a substrate 501, a light-emitting layer 502, an encapsulation layer 503, and a polarizing layer 504. For functions of the substrate 501, the light-emitting layer 502, and the encapsulation layer 503, refer to the LED display panel. A difference lies in that the light-emitting layer 402 of the LED display panel includes LEDs to form a pixel array, and the light-emitting layer 502 of the OLED display panel includes OLEDs to form a pixel array. Other similar parts are not described again. In addition, the OLED display panel may further include the polarizing layer 504. The polarizing layer 504 can reduce reflection intensity of the OLED display panel on external ambient light.

### 2. Transmissive layer 102

As shown in FIG. 1, the transmissive layer 102 is disposed close to the light exit surface of the display panel 101, and a first surface that is of the transmissive layer 102 and that is away from the display panel 101 is a rough surface. The first surface of the transmissive layer 102 may also be understood as the light exit surface of the transmissive layer 102, that is, a surface on which a light ray is transmitted by the transmissive layer 102, or may be understood as the light exit surface of the display screen 100, that is, a surface on which a light ray is emitted by the display screen 100.

The first surface of the transmissive layer 102 is a rough surface. Therefore, diffuse reflection may be performed on ambient light irradiated on the first surface, to achieve paper-like display effect. In particular, in common paper reading, paper can reflect ambient light in near-Lambertian (a kind of diffuse reflection). The Lambertian reflection means that when a light ray is incident to a reflective surface, intensity of a reflected light ray in all directions in hemisphere space of the reflective surface is the same, with an incident point as the center. For paper reading, when ambient light irradiates paper, in hemisphere space on the paper, intensity of reflected light rays of the ambient light in all directions is the same or similar. Therefore, near-Lambertian, that is, diffuse reflection similar to Lambertian reflection, may be achieved.

To achieve a same or similar display effect as paper reading, the first surface of the transmissive layer 102 in the paper-like display screen 100 is usually made into a rough surface, so that the first surface may also perform diffuse reflection on ambient light. As shown in FIG. 1, the first surface of the transmissive layer 102 includes a plurality of micro structural units, and each micro structural unit is a curved surface. When the ambient light irradiates the first surface, different micro structural units may reflect the ambient light in different directions, to implement diffuse reflection of the ambient light.

However, when reflecting the ambient light, the micro structural unit on the first surface generates different degrees of refraction on light rays of different sub-pixels. Therefore, a flash point occurs on the display screen 100. For example, FIG. 6a is a schematic diagram of luminance distribution in a monochrome display picture in a range of 8 mm × 8 mm when the first surface of the transmissive layer 102 is a smooth plane. The monochrome display picture may be a display picture of any one of red, green, and blue. X is any direction parallel to the display panel 101, and Y is a direction perpendicular to X. It can be learned from FIG. 6a that the display image includes pixel points arranged in an array, and each pixel point corresponds to a light ray generated by one pixel on the display panel. When the first surface of the transmissive layer 102 is a smooth plane, luminance of the display picture is evenly distributed, and luminance of different pixel points is the same or similar.

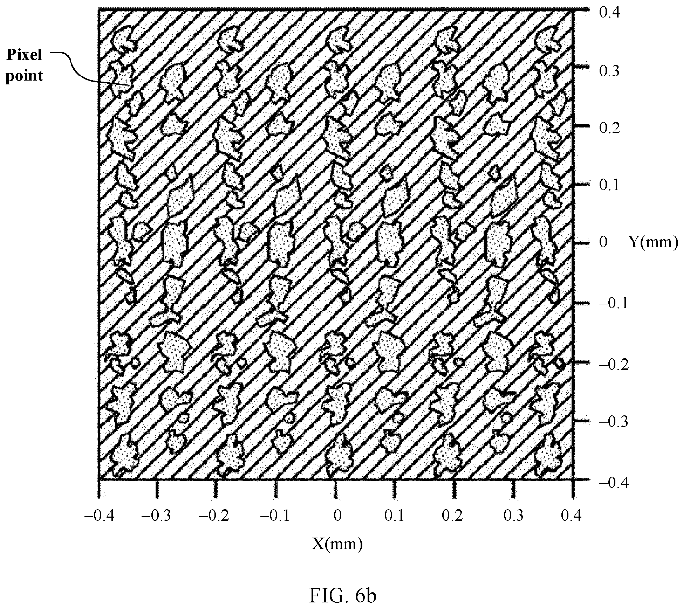

FIG. 6b is a schematic diagram of luminance distribution in a monochrome display picture in a range of 8 mm × 8 mm when the first surface of the transmissive layer 102 is a rough surface. It can be learned by comparing FIG. 6a and FIG. 6b that when the first surface of the transmissive layer 102 is a rough surface, regions with uneven luminance appear in the display picture, and luminance of a part of pixel points is low. These regions may also be referred to as speckles. In other words, the micro structural units on the first surface cause uneven luminance of the display picture.

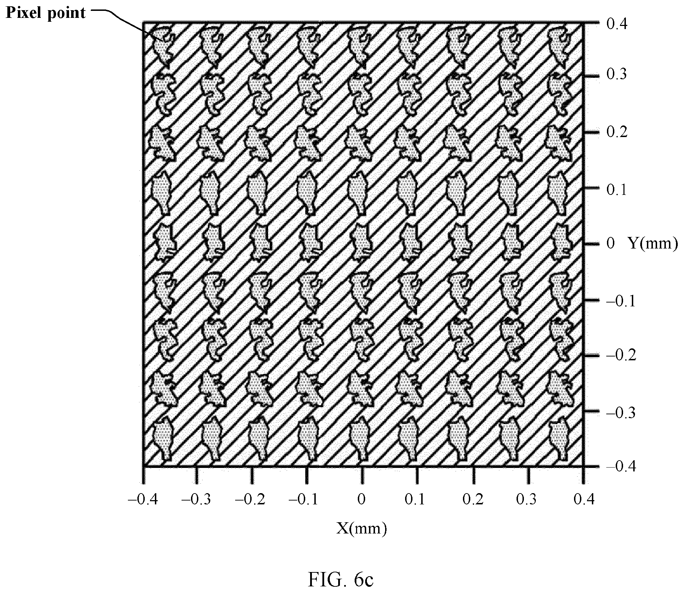

FIG. 6c is a schematic diagram of chrominance distribution in a monochrome display picture in a range of 8 mm x 8 mm when the first surface of the transmissive layer 102 is a smooth plane. It can be learned from FIG. 6c that when the first surface of the transmissive layer 102 is a smooth plane, chrominance distribution of the display picture is even, and chrominance of different pixel points is the same or similar.

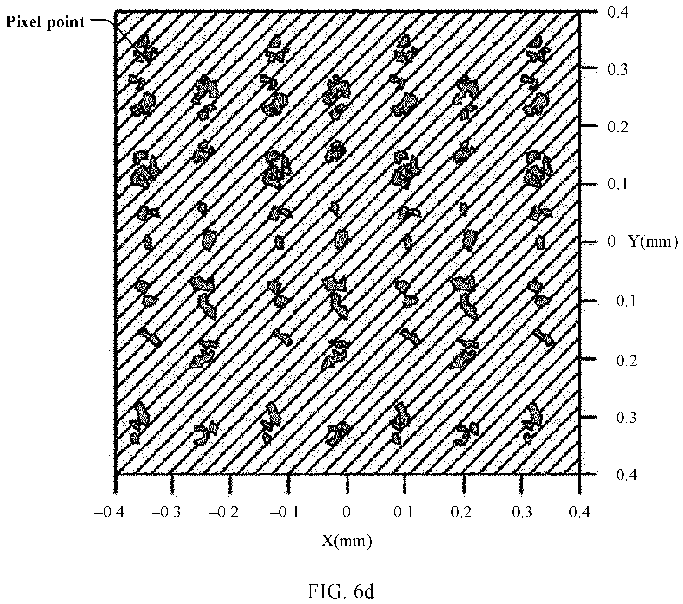

FIG. 6d is a schematic diagram of chrominance distribution in a monochrome display picture in a range of 8 mm × 8 mm when the first surface of the transmissive layer 102 is a rough surface. It can be learned by comparing FIG. 6c and FIG. 6d that when the first surface of the transmissive layer 102 is a rough surface, chrominance of the display picture is uneven, and chrominance of a part of pixel points is low. In other words, the micro structural units on the first surface cause uneven chrominance of the display picture.

The phenomenon of uneven luminance and chrominance of the display picture shown in FIG. 6b and FIG. 6d may also be referred to as a flash point. When the first surface is a rough surface, a flash point appears in the display picture mainly because a light refraction phenomenon occurs when a light ray generated by any sub-pixel passes through the micro structural unit. If a micro structural unit refracts light rays generated by a plurality of sub-pixels (a same color or different colors), because relative positions of the micro structural unit and the plurality of sub-pixels are inconsistent, the micro structural unit refracts light rays of different sub-pixels to different degrees. As a result, a ratio of three primary colors of each pixel point is deviated, which is reflected in a display picture, that is, the chrominance and luminance of the display picture are uneven, and a flash point occurs in the display picture.

For example, in FIG. 1, a micro structural unit A has different relative positions with a blue sub-pixel and a green sub-pixel in a pixel 1, so that the micro structural unit A refracts a light ray generated by the green sub-pixel to a small degree, and the micro structural unit A refracts a light ray generated by the blue sub-pixel to a large degree. As a result, a ratio of blue light intensity to green light intensity in the pixel 1 is deviated. When this ratio deviation is common in the transmissive light ray of the first surface, a flash point is generated.

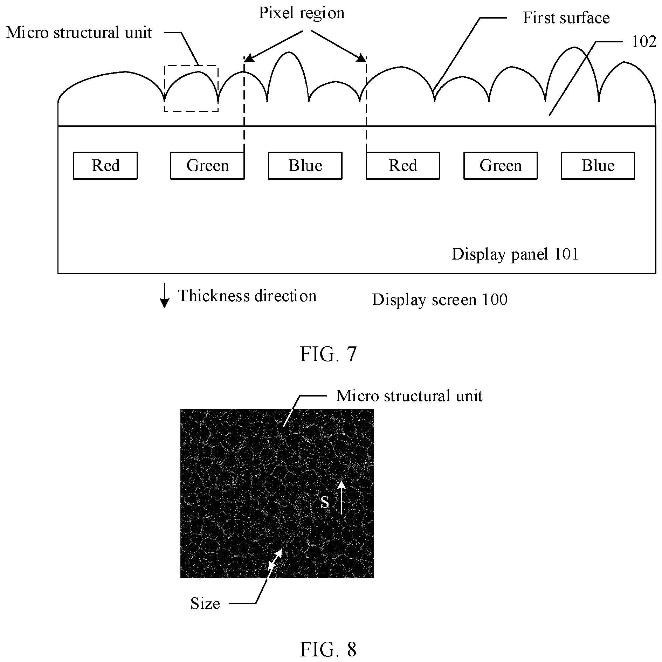

In view of this, in the display screen provided in this embodiment of this application, the first surface of the transmissive layer 102 is further improved. For example, FIG. 7 is a side section diagram of a display screen along a thickness direction according to an embodiment of this application. As shown in FIG. 7, a first surface of a transmissive layer 102 provided in this embodiment of this application includes a plurality of micro structural units, and these micro structural units are curved surfaces. An orthographic projection of each micro structural unit along a thickness direction is located in a pixel region, and a projection area of the micro structural unit is less than or equal to an area of the pixel region.

Specifically, a thickness direction of a display screen 100 may be shown by an arrow in FIG. 7, or may be understood as a direction that points vertically from the transmissive layer 102 to a display panel 101. It may be understood that a top view shape of the micro structural unit in the top view along the thickness direction is the same as a shape of an orthographic projection of the micro structural unit along the thickness direction. For example, FIG. 8 shows an example of a top view of a first surface along a thickness direction. As shown in FIG. 8, an enclosed region formed by white lines represents one micro structural unit. In the top view, a top view shape of the micro structural unit may be a regular shape, or may be an irregular shape. Top view shapes of different micro structural units may be the same or may be different. The micro structural units may be distributed regularly or irregularly on the first surface. This is not limited in this embodiment of this application.

In this embodiment of this application, a pixel region not only includes a region in which a sub-pixel is located on a display panel, but also includes a spaced region between the sub-pixel and another sub-pixel that is located around the sub-pixel and adjacent to the sub-pixel. A sub-pixel A in FIG. 3 is used as an example. There are eight adjacent sub-pixels around the sub-pixel A. In this case, the pixel region may be shown in FIG. 3, including a region in which the sub-pixel A is located and a spaced region between the sub-pixel A and the eight adjacent sub-pixels around the sub-pixel A.

An orthographic projection of a single micro structural unit is located in a pixel region, and a projection area of the single micro structural unit is less than or equal to an area of the pixel region. In other words, the orthographic projection of the single micro structural unit covers only a part or all of a region in which a maximum of one sub-pixel is located.

As shown in FIG. 7, for a pixel region in which a blue sub-pixel is located, orthographic projections of two micro structural units are located in the pixel region in which the blue sub-pixel is located. Therefore, the two micro structural units mainly bend light rays generated by the blue sub-pixel, and do not bend or only slightly bend light rays generated by a green sub-pixel and a red sub-pixel adjacent to the blue sub-pixel. Similarly, a micro structural unit with an orthographic projection located in a pixel region of the red sub-pixel mainly bends light rays generated by the red sub-pixel, and a micro structural unit with an orthographic projection located in a pixel region of the green sub-pixel mainly bends light rays generated by the green sub-pixel.

By using this structure, the single micro structural unit bending light rays generated by different sub-pixels can be avoided to some extent. Specifically, because the orthographic projection of the single micro structural unit covers only a part or all of the region in which a maximum of one sub-pixel is located, the micro structural unit mainly bends a light ray generated by the sub-pixel. As shown in FIG. 1, based on the analysis of the first surface, because a micro structural unit differently bends light rays of different sub-pixels, an intensity ratio of the three primary colors in the pixel is deviated, and consequently the flash point is generated. However, on the first surface shown in FIG. 7, each micro structural unit mainly bends a light ray of one color. This helps reduce a difference in light refraction degrees between different sub-pixels, and further helps optimize a flash point.

It should be noted that there may be an overlapping region between adjacent pixel regions, that is, a spaced region between adjacent sub-pixels. Although a micro structural unit with an orthographic projection located in the overlapping region may bend light rays of all adjacent sub-pixels, because positions of the adjacent sub-pixels relative to the micro structural unit are approximately symmetric, the micro structural unit bends the light rays of the adjacent sub-pixels to a similar degree. In addition, an area of an overlapping region between pixel regions is far less than an area of a region in which a sub-pixel is located. Therefore, a micro structural unit with an orthographic projection located in the overlapping region does not greatly affect a light intensity ratio between adjacent sub-pixels.

To further suppress the flash point, in a possible implementation, orthographic projections of at least two micro structural units are located in a sub-region of the pixel region. The sub-region includes a region in which the sub-pixel is located and a spaced region between the sub-pixel and any adjacent sub-pixel.

The pixel array shown in FIG. 3 is used as an example. A sub-region of a pixel region in which the sub-pixel A is located includes a region in which the sub-pixel A is located, and a spaced region a between the sub-pixel A and any adjacent pixel (for example, a pixel B). The orthographic projections of the at least two micro structural units being located in the sub-region may also be understood as that a maximum size of the micro structural unit is not greater than 1/2 of a pixel pitch (pixel pitch).

The size of the micro structural unit may be understood as a maximum value of a straight-line distance between two points on an edge of the top-view shape in a top-view shape of the micro structural unit along the thickness direction. For example, a size of any micro structural unit may be shown in FIG. 8. It should be understood that sizes of different micro structural units may be the same or may be different. In this embodiment of this application, the maximum size of the micro structural unit is a maximum value that can be reached by a size of each micro structural unit on the first surface, that is, the size of each micro structural unit is less than or equal to the maximum size.

The pixel pitch may be understood as a minimum repetition distance of a sub-pixel in a pixel array. The repetition distance is a sum of a size of a sub-pixel in a direction parallel to the pixel array and a spaced distance between the sub-pixel and any adjacent sub-pixel in the direction. Generally, for a same pixel array, a repetition distance varies with a change of the direction.

Generally, a minimum value of the repetition distance, that is, the minimum repetition distance, may be used as the pixel pitch. For example, in FIG. 3, if a repetition distance in the y direction shown by the arrow is the minimum repetition distance, the pixel pitch may be shown in FIG. 3, and is a sum of a size of a sub-pixel P1 in the y direction and a spaced distance between the sub-pixel P1 and a sub-pixel P2.

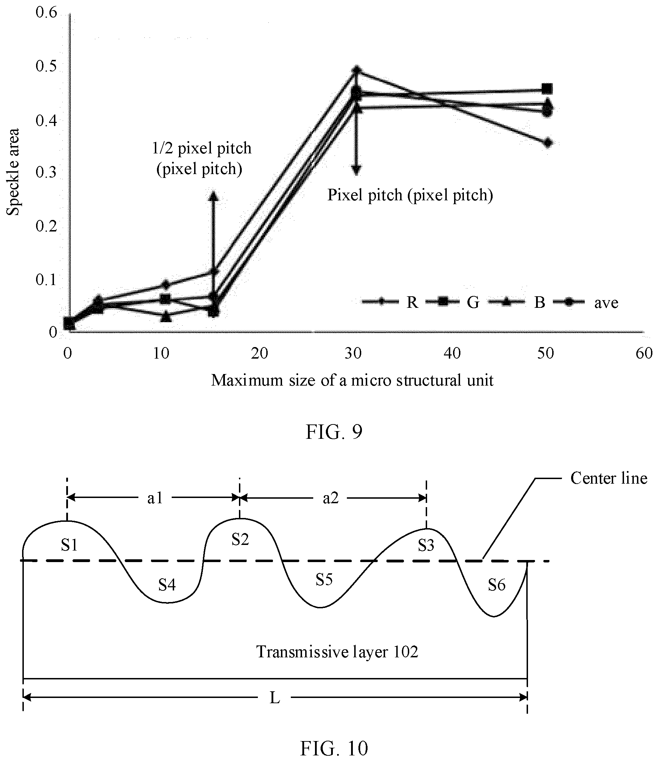

It is found through research that a speckle area in a display picture and a maximum size of a micro structural unit meet a relationship shown in FIG. 9. In FIG. 9, a horizontal coordinate represents a maximum size of the micro structural unit, and a vertical coordinate represents a speckle area in the display picture. FIG. 9 respectively shows display pictures of a red sub-pixel (R), a green sub-pixel (G), and a blue sub-pixel (B), and an average display effect (ave) of the three sub-pixels.

It can be learned from FIG. 9 that, the display pictures of the red sub-pixel (R), the green sub-pixel (G), and the blue sub-pixel (B), and the average display effect (ave) of the three sub-pixels all maintain a low speckle area when the maximum size of the micro structural unit is not greater than 1/2 of a pixel pitch. When the maximum size of the micro structural unit exceeds 1/2 of the pixel pitch, the speckle area increases rapidly with an increase of the maximum size of the micro structural unit. When the maximum size of the micro structural unit exceeds the pixel pitch, although a speckle area in a display picture of the red sub-pixel (R) decreases with an increase of the maximum size of the micro structural unit, an overall display effect cannot be improved. That is, the average display effect (ave) is still maintained at a large value.

In view of this, in the display screen provided in this embodiment of this application, the orthographic projections of the at least two micro structural units are located in the sub-region of the pixel region. In other words, the maximum size of the micro structural unit is not greater than 1/2 of the pixel pitch. This helps control the speckle area within a small range, and optimize the flash point.

To further suppress the flash point of the display screen 100, in a possible implementation, in any length range that is on the first surface and that is parallel to any direction of the display panel 101, a ratio Ra/Rsm of an arithmetic average height Ra of the plurality of micro structural units to an average length Rsm of contour curve elements of the plurality of micro structural units is greater than or equal to 0.5%.

The arithmetic average height Ra represents an arithmetic average value of absolute values of vertical distances between tangent-plane contour lines of the plurality of micro structural units and a center line in the any length range (for example, L) on a longitudinal tangent plane along the any direction and the thickness direction.

The center line is a straight line that is on the longitudinal tangent plane and that is parallel to the any direction, and a sum of areas of a plurality of regions formed by the tangent-plane contour lines of the plurality of micro structural units and the center line is the same as a sum of areas of a plurality of regions formed by tangent-plane contour lines of every two adjacent micro structural units and the center line.

For example, along an s direction in FIG. 8 and a thickness direction shown in FIG. 7, a longitudinal tangent plane of the transmissive layer 102 in the length L in the s direction may be shown in FIG. 10. There are a total of three micro structural units in the length L. A center line and tangent-plane contour lines of the three micro structural units form a plurality of regions (a region S1 to a region S6).

The region S1 to the region S3 are regions formed by the tangent-plane contour lines of the three micro structural units and the center line. The region S4 is a region formed by the tangent-plane contour line of the first micro structural unit, the tangent-plane contour line of the second micro structural unit, and the center line. The region S5 is a region formed by the tangent-plane contour line of the second micro structural unit, the tangent-plane contour line of the third micro structural unit, and the center line. The region S6 is a region formed by the tangent-plane contour line of the third micro structural unit, a tangent-plane contour line of a micro structural unit adjacent to the third micro structural unit, and the center line. In addition, a sum of areas of the region S1 to the region S3 is equal to a sum of areas of the region S4 to the region S6.

The arithmetic average height Ra represents an arithmetic average value of absolute values of vertical distances between tangent-plane contour lines of the three micro structural units and the center line in FIG. 10, and can reflect an average height of the three micro structural units. The height of each micro structural unit may be understood as a distance between a peak point and a valley bottom of the micro structural unit. Specifically, the peak point of the micro structural unit may be a point that is in the micro structural unit and that is at a maximum vertical distance from the display panel 101. The valley bottom of the micro structural unit may be understood as a point that is in the micro structural unit and that is at a minimum vertical distance from the display panel 101.

The average length Rsm of the contour curve elements represents an average value of projection lengths, on the center line, of connection lines between peak points of tangent-plane contour lines of every two adjacent micro structural units in the tangent-plane contour lines of the plurality of micro structural units in the any length range (for example, the length L) on the longitudinal tangent plane along the any direction and the thickness direction. The peak point of the tangent-plane contour line may be understood as a point that is in the tangent-plane contour line and that is at a maximum vertical distance from the display panel 101.

For example, in FIG. 10, a projection length of a connection line between a peak point of the first micro structural unit and a peak point of the second micro structural unit on the center line is a1, and a projection length of a connection line between the peak point of the second micro structural unit and a peak point of a third micro structural unit on the center line is a2. In this case, the average length Rsm of the contour curve element may be obtained through calculation based on an average value of a1 and a2. The average length Rsm of the contour curve element may represent a width state of the plurality of micro structural units.

It is found through research that a larger Ra/Rsm value is more conducive to suppressing a flash point. Therefore, in this embodiment of this application, a value of Ra/Rsm is not less than 0.5%, to further suppress the flash point.

In conclusion, using the first surface provided in this embodiment of this application helps suppress the flash point of the display panel 101 and implement paper-like display. For example, to achieve paper-like display effect, the first surface in this embodiment of this application may meet at least one of the following conditions:
Condition 1: Within any length range in any direction on the first surface, an arithmetic average height Ra of the plurality of micro structural units may be any value in [0.1 µm, 1 µm].

A specific definition of the arithmetic average height Ra is not described herein again. Specifically, the arithmetic average height Ra may be 0.1 µm, or may be 1 µm, or may be any value greater than 0.1 µm and less than 1 µm.

Further, the arithmetic average height Ra of the plurality of micro structural units may alternatively be any value in [0.2 µm, 0.5 µm]. Specifically, the arithmetic average height Ra may be 0.2 µm, or may be 0.5 µm, or may be any value greater than 0.2 µm and less than 0.5 µm. For example, the arithmetic average height Ra of the micro structural unit may be any value such as 0.2 µm, 0.25 µm, 0.3 µm, 0.34 µm, 0.4 µm, or 0.5 µm.

When the arithmetic average height Ra is excessively small, specular reflection is generated. This is not conducive to implementing paper-like display effect. When the arithmetic average height Ra is excessively large, definition of the display screen 100 is lowered, and display contrast is also lowered in ambient light. Therefore, in this embodiment of this application, the arithmetic average height Ra may be any value in [0.1 µm, 1 µm]. This helps maintain the definition of the display screen 100 and implement paper-like display.

In a possible implementation, a height of a single micro structural unit may be any value in [0.5 µm, 1.5 µm]. That is, the height of the micro structural unit may be 0.5 µm, or may be 1.5 µm, or may be any value greater than 0.5 µm and less than 1.5 µm. For example, the height of the micro structural unit may be any value such as 0.5 µm, 0.8 µm, 1 µm, 1.2 µm, or 1.5 µm.

Further, the height of each micro structural unit on the first surface may alternatively be any value in [1.5 µm, 4 µm]. Specifically, the height of each micro structural unit may be 1.5 µm, or may be 4 µm, or may be any value greater than 1.5 µm and less than 4 µm. For example, the height of the micro structural unit may be any value such as 1.5µm, 1.8µm, 2µm, 2.5µm, 2.7µm, 3µm, 3.4µm, 3.5µm, 3.8 µm, or 4 µm.

Condition 2: On the first surface, density of the micro structural units is not less than 5000/mm².

Specifically, there are at least 5000 micro structural units in a plane range of any 1 mm² on the first surface. It may be understood that, when the density of the micro structural units on the first surface is excessively small, specular reflection is also generated on the first surface. This is not conducive to implementing paper-like display effect. In view of this, in this embodiment of this application, the density of the micro structural units on the first surface is not less than 5000/mm², to prevent specular reflection from being generated on the first surface. This helps implement paper-like display effect.

Condition 3: Within a range of 1° deviation from a reflection angle, attenuation of reflected light of the first surface is less than 5%.

Specifically, when ambient light is irradiated on the first surface and reflected by the first surface, intensity of the reflected light is attenuated by less than 5% within the range of 1° deviation from the reflection angle. It may be understood that, if the intensity of the reflected light is attenuated greatly within the range of 1° deviation from the reflection angle, it indicates that the intensity of the reflected light is mostly concentrated within the range of 1° deviation from the reflection angle. In other words, reflection of the first surface to the ambient light is more inclined to be specular reflection rather than diffuse reflection.

Correspondingly, in this embodiment of this application, the attenuation of the reflected light of the first surface is less than 5% within the range of 1° deviation from the reflection angle, and a modulation transfer function (modulation transfer function, MTF) of a reflection image is less than 0.017. It is found through research that, in a medium luminance range of 11.89 to 142.3 cd/m², a relationship between a minimum visual perceptible difference luminance of human eyes and background luminance meets the Weber's Law, and a ratio of the two is approximately equal to 0.017. That is, when the modulation transfer function of the reflection image is greater than or equal to 0.017, the human eye can perceive the reflection image. In this application, the attenuation of the reflected light of the first surface is less than 5% within the range of 1° deviation from the reflection angle, so that the modulation transfer function MTF of the reflection image is less than 0.17, and the user cannot perceive specular reflection. This facilitates paper-like display.

Further, in this embodiment of this application, within the range of 1° deviation from the reflection angle, the attenuation of the reflected light of the first surface is any value in [5%, 10%]. This also helps suppress the flash point, and the user cannot perceive specular reflection. This facilitates paper-like display.

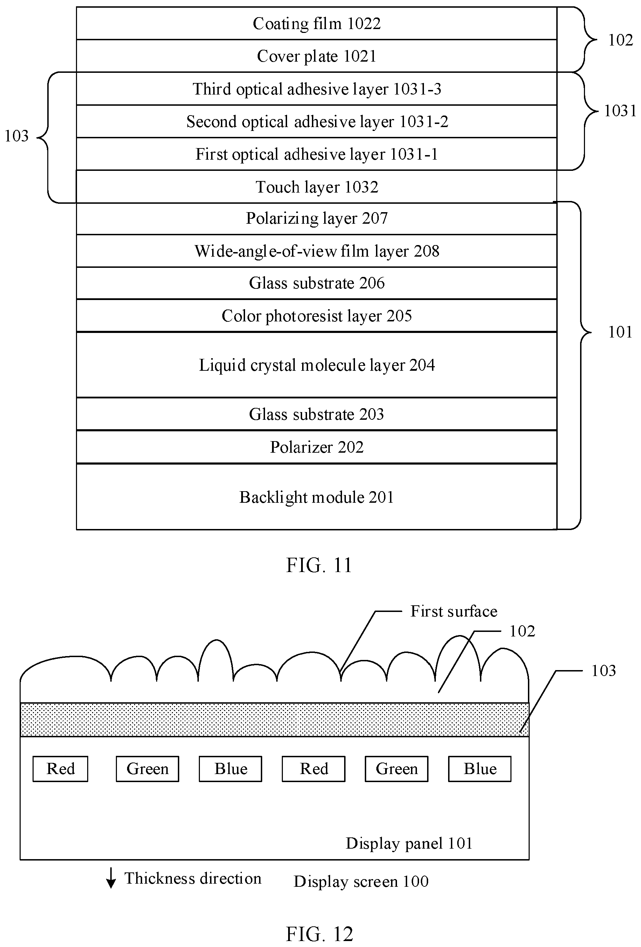

In this embodiment of this application, a specific structure of the transmissive layer 102 has a plurality of possible implementations. For example, as shown in FIG. 11, the transmissive layer 102 may include a cover plate 1021. The cover plate 1021 may be a glass cover plate or a flexible cover plate (a polymer film material). This is not limited in this embodiment of this application. One surface of the cover plate 1021 is fastened to the display panel 101, and the other surface of the cover plate 1021 may be used as the first surface of the transmissive layer 102. In other words, a light exit surface of the cover plate 1021 may be used as the first surface of the transmissive layer 102.

For example, the micro structural unit may be prepared on the surface of the cover plate 1021 in at least any one of the following manners:
Manner 1: Chemical etching. Specifically, the cover plate 1021 is etched through chemical frosting, and a size of the micro structural unit may be controlled to be 3 to 20 µm (a pixel pitch is not less than 40 µm) by adjusting a proportion of glass frosting powder NH₄F and NaF. That is, the size of the micro structural unit may be 3 µm, or may be 20 µm, or may be any value greater than 3 µm and less than 20 µm. By adjusting etching time and HF concentration, a variation range of the arithmetic average height Ra is controlled to be 0.01 to 10 µm. In addition, an initial Ra/Rsm for preparing the first surface ranges from 0.5% to 2%. That is, the initial Ra/Rsm may be 0.5%, or may be 2%, or may be any value greater than 0.5% and less than 2%.

After etching, the first surface is polished. Ra/Rsm is further corrected by further adjusting polishing time and a ratio of strong acid (H₂SO₄) in a polishing solution to an HF mass score, to control Ra/Rsm within a range not greater than 1.8%, and prevent an excessively large Ra/Rsm value from affecting definition of the display screen 100, and finally obtain a first surface that meets requirements of paper-like display and flash point suppression.

Method 2: Physical sandblasting. Specifically, a size of the micro structural unit may be controlled to be between 3 µm and 20 µm (a pixel pitch is not less than 40 µm) by controlling a size of sandblasting/shot blasting, Ra and Ra/Rsm are controlled to reach a proper range by controlling hardness of the sandblasting/shot blasting and pressure of compressed air, and then further topography correction is performed by polishing, to finally obtain a first surface that meets requirements of paper-like display and flash point suppression.

Method 3: Spray. Specifically, an inorganic or organic polymer material may be attached to a surface that is of the cover plate 1021 and that is away from the display panel 101, to form an unflat surface structure. Surface topography correction is performed by selecting different spraying materials and repeatedly coating, to finally obtain a first surface that meets requirements of paper-like display and flash point suppression.

Manner 4: Exposure developing process. Specifically, a surface that is of the cover plate 1021 and that is away from the display panel 101 may be coated with photoresist adhesive. After baking and curing, photoetching and developing is performed by using ultraviolet (ultraviolet, uv) light through a photomask with a specific pattern designed based on the desired topography. In a possible implementation, the developed photoresist adhesive is retained to implement a surface micro structural unit of a specific topography. That is, the micro structural unit on the first surface of the transmissive layer 102 is formed by using the retained developed photoresist adhesive. In another possible implementation, chemical etching may be performed on a surface of the developed cover plate 1021 by adding an etching process, to form a first surface having micro structural units. That is, the micro structural units on the first surface are formed on the surface of the cover plate 1021.

In another possible implementation, the transmissive layer 102 not only includes the cover plate 1021, but also may include a coating film 1022. One surface of the coating film 1022 is fastened to the cover plate 1021. In this case, the other surface of the coating film 1022 may be used as the first surface of the transmissive layer 102. For example, the coating film 1022 may be an anti-reflection coating film. For example, a reflectivity of the coating film 1022 to ambient light is less than or equal to 1%. Disposing the coating film 1022 helps suppress interference of ambient light to contrast of a display picture, and eliminate a "picture bleaching" problem caused by diffuse reflection.

In a case in which the transmissive layer 102 includes the cover plate 1021 and the coating film 1022, the micro structural unit may be prepared on the surface of the cover plate 1021, to obtain a first surface that meets requirements of paper-like display and flash point suppression. Alternatively, the micro structural unit may be prepared on the surface of the coating film 1022, to obtain a first surface that meets requirements of paper-like display and flash point suppression.

Specifically, in a possible implementation, after the micro structural unit is prepared on the surface of the cover plate 1021, the coating film 1022 is prepared on the surface of the cover plate 1021. Generally, a thickness of the coating film 1022 is small, and impact on topography of the micro structural unit may be ignored.

In another possible implementation, the coating film 1022 may alternatively be prepared on a surface (a smooth surface) of the cover plate 1021, and a micro structural unit may be prepared on a surface that is of the coating film 1022 and that is away from the cover plate 1021. For example, the micro structural unit may be prepared on the surface of the coating film 1022 in at least any one of the following manners:
Manner 1: The coating film 1022 is prepared by coating a surface of the cover plate 1021 with a polymer solution. Particles are added to the polymer solution. After the polymer solution is coated and cured, the particles in the polymer solution can protrude from the surface of the coating film 1022, so that a micro structural unit can be formed on the surface of the coating film 1022. Ra and Rsm are controlled by adjusting a particle size, a thickness of the coating film, and a particle density in the solution. In a possible implementation, a refractive index of the particle may be further adjusted to adjust haze of the first surface.
Manner 2: Coat a surface of the cover plate 1021 with a film-coated substrate, and further coat a surface of the film-coated substrate with two insoluble resins. Under specific conditions, the two insoluble resins are separated to form an unflat surface structure.
Manner 3: Coat a surface of the cover plate 1021 with a film-coated substrate, perform nano-imprinting on a surface of the film-coated substrate, and design a specific embossing abrasive to implement a first surface that meets requirements of paper-like display and flash point suppression.

It may be understood that, compared with preparing the micro structural unit on the surface of the cover plate 1021, an application scenario of preparing the micro structural unit on the surface of the coating film 1022 is more flexible, replacement is simple, a reliability requirement is low, and there are more options for manufacturing process.

To further suppress the flash point of the display screen, in a possible implementation, the display screen may further include an intermediate layer. In a possible implementation, the intermediate layer may be located between the display panel 101 and the transmissive layer 102. In another possible implementation, the intermediate layer may alternatively be located inside the display panel 101, and the intermediate layer is disposed close to the transmissive layer 102. The following describes the details based on different cases.

Case 1: The intermediate layer is located between the display panel 101 and the transmissive layer 102.

For example, as shown in FIG. 12, the display screen 100 further includes an intermediate layer 103 located between the display panel 101 and the transmissive layer 102. The intermediate layer 103 may scatter a display light ray generated by the display panel 101, to further suppress a flash point.

Specifically, it is found through research that, when a scattering degree of the display light ray is high, the flash point of the display screen 100 gradually decreases with an increase of the scattering degree of the display light ray. However, if a scattering capability of the first surface is excessively improved, definition of the display screen 100 is lowered.

In view of this, in this embodiment of this application, the intermediate layer 103 is disposed between the display panel 101 and the transmissive layer 102. Based on the first surface, the intermediate layer 103 further improves the scattering degree of the display light ray, to suppress the flash point of the display screen 100. In addition, compared with the first surface of the transmissive layer 102, the intermediate layer 103 may be disposed at a position closer to the display panel 101. This helps reduce impact on definition of the display screen 100.

For example, haze haze of the intermediate layer 103 may be any value in [5%, 40%]. Specifically, the haze of the intermediate layer may be 5%, or may be 40%, or may be any value greater than 5% and less than 40%. When the haze of the intermediate layer 103 is small, it is not enough to significantly suppress the flash point. When the haze of the intermediate layer 103 is large, definition of the display screen 100 is affected. In this embodiment of this application, the haze of the intermediate layer 103 is set to any value in [5%, 40%], to suppress the flash point and maintain the definition of the display screen 100. For example, the haze haze of the intermediate layer 103 may be any value of 5%, 7%, 8%, 10%, 12%, 15%, 20%, 22%, 23%, 25%, 30%, 33%, 35%, or 40%.

In this embodiment of this application, haze haze of the intermediate layer 103 may alternatively be any value in [40%, 95%]. In other words, the haze of the intermediate layer may be 40%, or may be 95%, or may be any value greater than 40% and less than 95%. For example, the value may be any value such as 40%, 45%, 50%, 55%, 60%, 67%, 70%, 72%, 78%, 80%, 85%, 90%, or 92%. In this solution, the flash point can be suppressed while the definition of the display screen can be maintained.

In a possible implementation, a specific material may be selected for the intermediate layer 103, so that the intermediate layer 103 may scatter the display light ray.

In another possible implementation, the intermediate layer 103 may include a scattering particle, and the scattering particle may be configured to adjust the haze of the intermediate layer 103. For example, a scattering capability (the haze) of the intermediate layer 103 may be adjusted by changing a plurality of factors such as a concentration of the scattering particle, a refractive index of the scattering particle, and a size of the scattering particle.

Generally, the refractive index of the scattering particle may be any value in [1.4, 2.5]. In other words, the refractive index of the scattering particle may be 1.4, or may be 2.5, or may be any value greater than 1.4 and less than 2.5.

To further suppress the flash point, in a possible implementation, an area of an orthographic projection of the scattering particle along the thickness direction is not greater than an area of the orthographic projection of the micro structural unit along the thickness direction. In this case, similar to the micro structural unit, the scattering particle in the intermediate layer 103 bends only a light ray generated by one sub-pixel, and the light ray bent by the scattering particle is incident to a corresponding micro structural unit. Therefore, different micro structural units may receive similar incident light rays. This further helps suppress the flash point. Generally, to maintain the scattering capability of the scattering particle, a size of the scattering particle needs to be greater than 1 µm.

It should be noted that, the intermediate layer 103 shown in FIG. 8 may be directly added to an existing structure of the display screen 100, or may be implemented based on an original functional layer of the display screen 100. In other words, the intermediate layer 103 may further implement another function while scattering the display light ray.

For example, the intermediate layer 103 may include an optical adhesive layer. For example, as shown in FIG. 7, an optical adhesive layer 1031 is disposed between the display panel 101 and the transmissive layer 102, and the optical adhesive layer 1031 includes a scattering particle, so that a display light ray generated by the display panel 101 can be scattered. In addition, the optical adhesive layer 1031 may further fasten the display panel 101 and the transmissive layer 102. This implementation has little impact on a structure of the display screen 100, and is easy to implement.

In a possible implementation, as shown in FIG. 7, the optical adhesive layer 1031 may include a first optical adhesive layer 1031-1, a second optical adhesive layer 1031-2, and a third optical adhesive layer 1031-3. The second optical adhesive layer 1031-2 includes the foregoing scattering particle, and the first optical adhesive layer 1031-1 and the third optical adhesive layer 1031-3 may be optical adhesive layers of a conventional material. The first optical adhesive layer 1031-1 is disposed on a surface that is of the second optical adhesive layer 1031-2 and that is close to the display panel 101, and the third optical adhesive layer 1031-3 is disposed on a surface that is of the second optical adhesive layer 1031-2 and that is close to the transmissive layer 102.

In this implementation, the optical adhesive layer 1031 is of a sandwich structure. The second optical adhesive layer 1031-2 may have a function of enhancing scattering, and the first optical adhesive layer 1031-1 and the third optical adhesive layer 1031-3 may maintain an original function of the optical adhesive layer 1031, to prevent the scattering particle from affecting an adhesive effect of the optical adhesive layer 1031.

For another example, as shown in FIG. 11, the display screen 100 may be a touchscreen. In this case, the intermediate layer 103 may further include a touch layer 1032. The touch layer 1032 may generate a touch signal, so that the display screen 100 may implement a touch function. For example, the touch layer 1032 may include a sensor array, and may sense an operation gesture of the user on the surface of the display screen 100, to generate a touch signal. In this embodiment of this application, a scattering particle may be further added to the touch layer 1032, so that the touch layer 1032 can scatter the display light ray.

Case 2: The intermediate layer is located inside the display panel 101 and/or the transmissive layer 102. For example, both a display panel 101 (shown in FIG. 2) of the LCD and a display panel 101 (shown in FIG. 5) of the OLED include a polarizing layer. A scattering particle may be disposed at the polarizing layer as the intermediate layer 103. For example, the scattering particle may be added to a tri-cellulose acetate (tri-cellulose acetate, TCA) of the polarizing layer, to reduce interference on an original function of the polarizing layer.

It should be noted that, in this embodiment of this application, the scattering particle may be disposed not only in the intermediate layer, but also in another layer structure located in a transmissive path of the display light ray. For example, a scattering particle may also be added to the cover plate 1021, to suppress the flash point of the display screen 100. Details are not described again.

In a possible implementation, the display panel 101 may further include a wide-angle-of-view film layer 208. The wide-angle-of-view film layer 208 may expand an angle of view of the display light ray, so that spatial distribution of the display light ray is more similar to that of a paper reflection light ray, to further optimize paper-like display effect. Similarly, a diffusion sheet may also be disposed in the backlight module 201, so that an angle of view of the display light ray can also be expanded, and paper-like display effect can be optimized. In addition, disposing the diffusion sheet may further reduce flash points generated by internal interference of the display panel 101. This is also conducive to further optimizing the flash point.

Based on a same technical concept, an example of this application further provides a display screen protective film. The display screen protective film may be laminated to a light exit surface of the display screen by pasting or vacuum adsorption. The display screen protective film includes a rough surface. The rough surface may include a plurality of micro structural units. An orthographic projection of each micro structural unit along a thickness direction is located in a pixel region, and a projection area of the micro structural unit is less than or equal to an area of the pixel region. The micro structural unit is a curved surface. In this embodiment of this application, the pixel region includes a region in which a sub-pixel is located on the display screen and a spaced region between the sub-pixel and another sub-pixel that is located around the sub-pixel and adjacent to the sub-pixel.

The display screen protective film provided in this example of this application can enable a non-paper-like display screen to implement paper-like display, and can further suppress a flash point. The rough surface of the display screen protective film provided in this embodiment of this application has a topography feature similar to that of the first surface of the transmissive layer 102. Details are not described again.

To further suppress the flash point, in a possible implementation, orthographic projections of at least two micro structural units are located in a sub-region of the pixel region. The sub-region may include a region in which the sub-pixel is located and a spaced region between the sub-pixel and any adjacent sub-pixel.

Generally, a height of each micro structural unit is any value in [0.5 µm, 1.5 µm]. The height of each micro structural unit is a distance between a peak point and a valley bottom of the micro structural unit. Specifically, the peak point of the micro structural unit is a point that is in the micro structural unit and that is at a maximum distance from the display screen. The valley bottom of the micro structural unit is a point that is in the micro structural unit and that is at a minimum distance from the display screen. For example, the height of the micro structural unit may be any value such as 0.5 µm, 0.8 µm, 1 µm, 1.2 µm, or 1.5 µm.

Further, a height of the micro structural unit may be any value in [1.5 µm, 4 µm]. Specifically, the height of each micro structural unit may be 1.5 µm, or may be 4 µm, or may be any value greater than 1.5 µm and less than 4 µm. For example, the height of the micro structural unit may be any value such as 1.5µm, 1.8µm, 2µm, 2.5µm, 2.7µm, 3µm, 3.4µm, 3.5µm, 3.8 µm, or 4 µm.

To improve paper-like display effect, in a possible implementation, in any length range that is on the rough surface and that is parallel to any direction of the display screen, an arithmetic average height Ra of the plurality of micro structural units is any value in [0.1 µm, 1 µm]. The arithmetic average height Ra represents an arithmetic average value of absolute values of vertical distances between tangent-plane contour lines of the plurality of micro structural units and a center line in the any length range on a longitudinal tangent plane along the any direction and the thickness direction. The center line is a straight line that is on the longitudinal tangent plane and that is parallel to the any direction, and a sum of areas of a plurality of regions formed by the tangent-plane contour lines of the plurality of micro structural units and the center line is the same as a sum of areas of a plurality of regions formed by tangent-plane contour lines of every two adjacent micro structural units and the center line.

Further, the arithmetic average height Ra of the plurality of micro structural units may alternatively be any value in [0.2 µm, 0.5 µm]. Specifically, the arithmetic average height Ra may be 0.2 µm, or may be 0.5 µm, or may be any value greater than 0.2 µm and less than 0.5 µm. For example, the arithmetic average height Ra of the micro structural unit may be any value such as 0.2µm, 0.25µm, 0.3µm, 0.34µm, 0.4 µm, or 0.5 µm.

To improve paper-like display effect, in a possible implementation, on the rough surface, density of the micro structural units is greater than or equal to 5000/mm².

To further suppress the flash point, in any length range that is on the rough surface and that is parallel to any direction of the display screen, a ratio Ra/Rsm of an arithmetic average height Ra of the plurality of micro structural units to an average length Rsm of contour curve elements of the plurality of micro structural units is greater than or equal to 0.5%. A meaning of the arithmetic average height Ra is not described again. The average length Rsm of the contour curve elements represents an average value of projection lengths, on the center line, of connection lines between peak points of tangent-plane contour lines of every two adjacent micro structural units in the tangent-plane contour lines of the plurality of micro structural units in the any length range on the longitudinal tangent plane along the any direction and the thickness direction. A peak point of the tangent-plane contour line is a point that is in the tangent-plane contour line and that is farthest from the display screen.

In a possible implementation, the display screen protective film is an anti-reflection coating film, to help suppress interference of ambient light to contrast of a display picture, and eliminate a "picture bleaching" problem caused by diffuse reflection.

## Claims

1. A display screen (100) comprising a display panel (101) and a transmissive layer (102) that are sequentially stacked, wherein:
• the display panel (101) is configured to generate a display light ray; and
• the transmissive layer (102) is configured to transmit the display light ray, wherein the transmissive layer (102) has a first surface away from the display panel (101), the first surface comprises a plurality of micro structural units, orthographic projections of at least two micro structural units are located in a sub-region of a pixel region of the display panel (101), and the sub-region comprises a region in which a sub-pixel of the display panel (101) is located and a spaced region between the sub-pixel and any adjacent sub-pixel of the display panel (101), wherein a maximum size of a micro structural unit is not greater than 1/2 of a pixel pitch, and wherein in any length range that is on the first surface and that is parallel to any direction of the display panel (101), a ratio Ra/Rsm of an arithmetic average height Ra of the plurality of micro structural units to an average length Rsm of contour curve elements of the plurality of micro structural units is greater than or equal to 0.5%,
wherein
o the arithmetic average height Ra represents an arithmetic average value of absolute values of vertical distances between tangent-plane contour lines of the plurality of micro structural units and a center line in the any length range on a longitudinal tangent plane along the any direction and the thickness direction, wherein the center line is a straight line that is on the longitudinal tangent plane and that is parallel to the any direction, and a sum of areas of a plurality of regions formed by the tangent-plane contour lines of the plurality of micro structural units and the center line is the same as a sum of areas of a plurality of regions formed by tangent-plane contour lines of every two adjacent micro structural units and the center line; and
∘ the average length Rsm of the contour curve elements represents an average value of projection lengths, on the center line, of connection lines between peak points of tangent-plane contour lines of every two adjacent micro structural units in the tangent-plane contour lines of the plurality of micro structural units in the any length range on the longitudinal tangent plane along the any direction and the thickness direction, wherein a peak point of each tangent-plane contour line is a point that is in the tangent-plane contour line and that is farthest from the display panel.

2. The display screen (100) according to claim 1, wherein a height of each micro structural unit is any value in [0.5 µm, 1.5 µm], the height of each micro structural unit is a distance between a peak point and a valley bottom of the micro structural unit, the peak point of the micro structural unit is a point that is in the micro structural unit and that is at a maximum distance from the display panel, and the valley bottom of the micro structural unit is a point that is in the micro structural unit and that is at a minimum distance from the display panel.

3. The display screen (100) according to claim 1, wherein a height of each micro structural unit is any value in [1.5 µm, 4 µm], the height of each micro structural unit is a distance between a peak point and a valley bottom of the micro structural unit, the peak point of the micro structural unit is a point that is in the micro structural unit and that is at a maximum distance from the display panel, and the valley bottom of the micro structural unit is a point that is in the micro structural unit and that is at a minimum distance from the display panel.

4. The display screen (100) according to claim 1, wherein in any length range that is on the first surface and that is parallel to any direction of the display panel, the arithmetic average height Ra of the plurality of micro structural units is any value in [0.1 µm, 1 µm].

5. The display screen according to claim 1, wherein on the first surface, a density of the micro structural unit is greater than or equal to 5000/mm².

6. The display screen (100) according to claim 1, wherein within a range of 1° deviation from a reflection angle, an attenuation of reflected light of the first surface is less than or equal to 5%.

7. The display screen (100) according to claim 1, wherein within a range of 1° deviation from a reflection angle, an attenuation of reflected light of the first surface is any value in [5%, 10%].

8. An electronic device comprising the display screen according to any one of claims 1 to 7.

## Patentansprüche

1. Anzeigeschirm (100), der ein Anzeigepanel (101) und eine durchlässige Schicht (102) umfasst, die sequenziell gestapelt sind, wobei
• das Anzeigepanel (101) ausgelegt ist zum Erzeugen eines Anzeigelichtstrahls; und
• die durchlässige Schicht (102) ausgelegt ist zum Durchlassen des Anzeigelichtstrahls, wobei die durchlässige Schicht (102) eine von dem Anzeigepanel (101) weggewandte erste Oberfläche aufweist, die erste Oberfläche mehrere Mikrostruktureinheiten umfasst, sich orthographische Projektionen von mindestens zwei Mikrostruktureinheiten in einer Teilregion einer Pixelregion des Anzeigepanels (101) befinden und die Teilregion eine Region, in der sich ein Subpixel des Anzeigepanels (101) befindet, und eine beabstandete Region zwischen dem Subpixel und jedem angrenzenden Subpixel des Anzeigepanels (101) umfasst, wobei eine maximale Größe einer Mikrostruktureinheit nicht mehr als ½ eines Pixelabstands beträgt, und wobei in einem beliebigen Längenbereich, der sich auf der ersten Oberfläche befindet und der zu einer beliebigen Richtung des Anzeigepanels (101) parallel ist, ein Verhältnis Ra/Rsm einer arithmetischen mittleren Höhe Ra der mehreren Mikrostruktureinheiten zu einer mittleren Länge Rsm von Konturkurvenelementen der mehreren Mikrostruktureinheiten größer oder gleich 0,5% ist,
wobei
o die arithmetische mittlere Höhe Ra einen arithmetischen Mittelwert von Absolutwerten vertikaler Distanzen zwischen Tangentialebenen-Konturlinien der mehreren Mikrostruktureinheiten und einer Mittellinie in dem beliebigen Längenbereich auf einer longitudinalen Tangentialebene entlang der beliebigen Richtung und der Dickenrichtung repräsentiert, wobei die Mittellinie eine gerade Linie ist, die sich auf der longitudinalen Tangentialebene befindet und die zu der beliebigen Richtung parallel ist, und eine Summe von Flächen von mehreren Regionen, die durch die Tangentialebenen-Konturlinien der mehreren Mikrostruktureinheiten und die Mittellinie gebildet werden, dieselbe wie eine Summe von Flächen mehrerer Regionen ist, die durch die Tangentialebenen-Konturlinien von jeweils zwei angrenzenden Mikrostruktureinheiten und die Mittellinie gebildet werden; und
∘ die mittlere Länge Rsm der Konturkurvenelemente einen Mittelwert von Projektionslängen auf der Mittellinie von Verbindungslinien zwischen Spitzenpunkten von Tangentialebenen-Konturlinien von jeweils zwei angrenzenden Mikrostruktureinheiten in den Tangentialebenen-Konturlinien der mehreren Mikrostruktureinheiten in dem beliebigen Längenbereich auf der longitudinalen Tangentialebene entlang der beliebigen Richtung und der Dickenrichtung repräsentiert, wobei ein Spitzenpunkt jeder Tangentialebenen-Konturlinie ein Punkt ist, der sich in der Tangentialebenen-Konturlinie befindet und der von dem Anzeigepanel am weitesten entfernt ist.

2. Anzeigeschirm (100) nach Anspruch 1, wobei eine Höhe jeder Mikrostruktureinheit ein beliebiger Wert in [0,5 µm, 1,5 µm] ist, die Höhe jeder Mikrostruktureinheit eine Distanz zwischen einem Spitzenpunkt und einem Talgrund der Mikrostruktureinheit ist, der Spitzenpunkt der Mikrostruktureinheit ein Punkt ist, der sich in der Mikrostruktureinheit befindet und der sich in einer maximalen Distanz von dem Anzeigepanel befindet, und der Talgrund der Mikrostruktureinheit ein Punkt ist, der sich in der Mikrostruktureinheit befindet und der sich in einer kleinsten Distanz von dem Anzeigepanel befindet.

3. Anzeigeschirm (100) nach Anspruch 1, wobei eine Höhe jeder Mikrostruktureinheit ein beliebiger Wert in [1,5 µm, 4 µm] ist, die Höhe jeder Mikrostruktureinheit eine Distanz zwischen einem Spitzenpunkt und einem Talgrund der Mikrostruktureinheit ist, der Spitzenpunkt der Mikrostruktureinheit ein Punkt ist, der sich in der Mikrostruktureinheit befindet und der sich in einer maximalen Distanz von dem Anzeigepanel befindet, und der Talgrund der Mikrostruktureinheit ein Punkt ist, der sich in der Mikrostruktureinheit befindet und der sich in einer kleinsten Distanz von dem Anzeigepanel befindet.

4. Anzeigeschirm (100) nach Anspruch 1, wobei in einem beliebigen Längenbereich, der sich auf der ersten Oberfläche befindet und der zu einer beliebigen Richtung des Anzeigepanels parallel ist, die arithmetische mittlere Höhe Ra der mehreren Mikrostruktureinheiten ein beliebiger Wert in [0,1 µm, 1 µm] ist.

5. Anzeigeschirm (100) nach Anspruch 1, wobei auf der ersten Oberfläche eine Dichte der Mikrostruktureinheit größer oder gleich 5000/mm² ist.

6. Anzeigeschirm (100) nach Anspruch 1, wobei innerhalb eines Bereichs von 1° Abweichung von einem Reflexionswinkel eine Dämpfung von reflektiertem Licht der ersten Oberfläche kleiner oder gleich 5% ist.

7. Anzeigeschirm (100) nach Anspruch 1, wobei innerhalb eines Bereichs von 1° Abweichung von einem Reflexionswinkel eine Dämpfung von reflektiertem Licht der ersten Oberfläche ein beliebiger Wert in [5%, 10%] ist.

8. Elektronische Vorrichtung, die den Anzeigeschirm nach einem der Ansprüche 1 bis 7 umfasst.

## Revendications

1. Écran (100) d'affichage comportant un panneau (101) d'affichage et une couche transmissive (102) qui sont empilés séquentiellement,
• le panneau (101) d'affichage étant configuré pour générer un rayon lumineux d'affichage ; et
• la couche transmissive (102) étant configurée pour transmettre le rayon lumineux d'affichage, la couche transmissive (102) présentant une première surface éloignée du panneau (101) d'affichage, la première surface comportant une pluralité d'unités de microstructure, des projections orthographiques d'au moins deux unités de microstructure étant situées dans une sous-région d'une région de pixels du panneau (101) d'affichage, et la sous-région comportant une région dans laquelle est situé un sous-pixel du panneau (101) d'affichage et une région espacée entre le sous-pixel et un quelconque sous-pixel adjacent du panneau (101) d'affichage, une taille maximum d'une unité de microstructure n'étant pas supérieure à 1/2 d'un pas de pixels, et dans toute plage de longueur qui se trouve sur la première surface et qui est parallèle à une direction quelconque du panneau (101) d'affichage, un rapport Ra/Rsm d'une hauteur moyenne arithmétique Ra de la pluralité d'unités de microstructure à une longueur moyenne Rsm d'éléments de courbes d'isovaleurs de la pluralité d'unités de microstructure étant supérieur ou égal à 0,5%,
∘ la hauteur moyenne arithmétique Ra représentant une valeur moyenne arithmétique de valeurs absolues de distances verticales entre des lignes d'isovaleurs de plan tangent de la pluralité d'unités de microstructure et une ligne médiane dans la plage de longueur quelconque sur un plan tangent longitudinal suivant la direction quelconque et la direction de l'épaisseur, la ligne médiane étant une ligne droite qui se trouve sur le plan tangent longitudinal et qui est parallèle à la direction quelconque, et une somme des aires d'une pluralité de régions formées par les lignes d'isovaleurs de plan tangent de la pluralité d'unités de microstructure et la ligne médiane est la même qu'une somme des aires d'une pluralité de régions formées par des lignes d'isovaleurs de plan tangent de chaque paire d'unités de microstructure adjacentes et la ligne médiane ; et
o la longueur moyenne Rsm des éléments de courbes d'isovaleurs représentant une valeur moyenne de longueurs de projection, sur la ligne médiane, de lignes de raccordement entre des points de crête de lignes d'isovaleurs de plan tangent de chaque paire d'unités de microstructure adjacentes dans les lignes d'isovaleurs de plan tangent de la pluralité d'unités de microstructure dans la plage de longueur quelconque sur le plan tangent longitudinal suivant la direction quelconque et la direction de l'épaisseur, un point de crête de chaque ligne d'isovaleur de plan tangent étant un point qui appartient à la ligne d'isovaleur de plan tangent et qui est le plus éloigné du panneau d'affichage.

2. Écran (100) d'affichage selon la revendication 1, une hauteur de chaque unité de microstructure étant une valeur quelconque dans [0,5 µm, 1,5 µm], la hauteur de chaque unité de microstructure étant une distance entre un point de crête et un fond de vallée de l'unité de microstructure, le point de crête de l'unité de microstructure étant un point qui appartient à l'unité de microstructure et qui se trouve à une distance maximum du panneau d'affichage, et le fond de vallée de l'unité de microstructure étant un point qui appartient à l'unité de microstructure et qui se trouve à une distance minimum du panneau d'affichage.

3. Écran (100) d'affichage selon la revendication 1, une hauteur de chaque unité de microstructure étant une valeur quelconque dans [1,5 µm, 4 µm], la hauteur de chaque unité de microstructure étant une distance entre un point de crête et un fond de vallée de l'unité de microstructure, le point de crête de l'unité de microstructure étant un point qui appartient à l'unité de microstructure et qui se trouve à une distance maximum du panneau d'affichage, et le fond de vallée de l'unité de microstructure étant un point qui appartient à l'unité de microstructure et qui se trouve à une distance minimum du panneau d'affichage.

4. Écran (100) d'affichage selon la revendication 1, dans une plage de longueur quelconque qui se trouve sur la première surface et qui est parallèle à une direction quelconque du panneau d'affichage, la hauteur moyenne arithmétique Ra de la pluralité d'unités de microstructure étant une valeur quelconque dans [0.1 µm, 1 µm].

5. Écran d'affichage selon la revendication 1, sur la première surface, une densité des unités de microstructure étant supérieure ou égale à 5000/mm².

6. Écran (100) d'affichage selon la revendication 1, à l'intérieur d'une plage d'écart de 1° par rapport à un angle de réflexion, une atténuation de la lumière réfléchie de la première surface étant inférieure ou égale à 5%.

7. Écran (100) d'affichage selon la revendication 1, à l'intérieur d'une plage d'écart de 1° par rapport à un angle de réflexion, une atténuation de la lumière réfléchie de la première surface étant une valeur quelconque dans [5%, 10%].

8. Dispositif électronique comportant l'écran d'affichage selon l'une quelconque des revendications 1 à 7.
